# EUROPEAN PATENT APPLICATION

(11) **EP 4 304 309 A1**
(43) Date of publication of application: **10.01.2024**
(21) Application number: 22182751.2
(22) Date of filing: 04.07.2022
(51) Int. Cl.: H05K 7/20, G06F 1/20

(54) **METHOD FOR UTILIZING WASTE HEAT FROM COMPUTING DEVICES**

(71) Applicant: FairMaid AB, 13161 Nacka (SE)
(72) Inventor: McArthur, Ken, 13161 Nacka (SE); McArthur, David, 13161 Nacka (SE)
(74) Representative: AWA Sweden AB

(57) **Abstract**

There is disclosed herein a method for controlling one or more computing devices, wherein the one or more computing devices are at least partially submerged in a liquid reservoir and arranged part of a system further comprising a heating arrangement configured to heat an internal space using heat from the liquid reservoir. The control method comprises performing computing tasks with a computing capacity of the one or more computing devices, thereby generating waste heat, such that the liquid reservoir is heated by the waste heat. The method further comprises transferring heat from the liquid reservoir to a heating arrangement for heating an internal space. The one or more computing devices are controlled to maximize the utilization of the computing capacity and optimize energy usage.

## Description

### Technical Field

The present invention relates to a method for utilizing waste heat from computing devices, and a system for implementing said method.

### Background

Waste heat from computing devices is typically treated as something to be reduced and managed in such a way as to remove said waste heat into an ambient environment. Data center cooling ability is commonly expressed in terms of power right per square meter (higher numbers indicate better cooling), and/or a ratio of total power consumption and power used by the computers, referred to as the Power Usage Effectiveness, or 'PUE'. Viewed from another perspective, it is common for a computing device to be limited in its performance by the rate at which it can be cooled.

As such, it is conventional to minimize the computational burden on computing devices so as not to cause them to overheat, and to vent the waste heat from said computing devices, when operated, to an environment that is thermally separate from said computing devices, such as the outside air or at least outside of a casing that houses said computing devices.

### Summary

The present disclosure provides a method for utilizing waste heat from computing devices, such that the waste heat is not treated as something to be minimized and/or disposed of, but instead as something valuably (re)usable.

In particular, according to an aspect of the present disclosure, there is provided a method for controlling one or more computing devices, which may be performed with a system containing said one or more computing devices, as well as a heating arrangement and a controller configured to carry out the method.

The controller may be included as part of the one or more computing devices (e.g. as a software element) or it may be a separate hardware element, or some combination of hardware and software. For example, the system may comprise a user device having a user interface for receiving user input, and the user device may form part of and/or communicate with the controller.

In any event, it will be appreciated that any suitable means for controlling the one or more computing devices could be implemented, wherein steps of the control method may be performed by a same or multiple different components of an entity which herein shall be generally referred to as a 'controller'.

The method for controlling the one or more computing devices may comprise performing computing tasks with a computing capacity of the one or more computing devices, thereby generating waste heat. As used herein, the computing capacity' of the one or more computing devices may refer to the processing capacity/ability of the computing devices, which may be determined by a performance rating and/or number of processors (or 'cores') in the one or more computing devices.

A computing device may contain one or more general purpose central processing units (CPUs), one or more graphics processing units (GPUs), one or more hardware devices with a specific or specialized purpose, such as an application-specific integrated chip (ASIC), memory device(s), storage device(s), and/or other such hardware. The performance of a computing device may be based on all components in combination. It will be appreciated that some computing tasks may perform better on particular hardware.

The computing tasks performed by the computing devices may take any form, such as data processing for commercial, scientific, or private purposes, etc. It may be considered that substantially all of the heat generated as a result of performing such computing tasks is 'waste' heat, at least in the sense that heat is not intended for any other practical purpose, and is merely a byproduct from the performance of the computing tasks.

According to the presently disclosed technique, the one or more computing devices may be at least partially submerged in a liquid reservoir, and in some examples completely submerged in a liquid reservoir, such that the liquid reservoir is heated by the waste heat. The liquid reservoir may contain a dielectric liquid so as not to cause short-circuiting of the computing devices. Additionally or alternatively, components of the computing devices may be coated in a waterproof coating such that a conductive liquid (e.g. water) may be used in the liquid reservoir. Additionally or alternatively, liquid coolant may be piped through or next to components, for example the components that create (or are expected to create) the greatest heat load.

The method may then comprise transferring heat from the liquid reservoir to a heating arrangement for heating an internal space. The liquid reservoir may be in direct or indirect thermal communication with the heating arrangement, e.g., in fluid communication with the heating arrangement or connected thereto via a heat exchanger. It will be appreciated that, in preferred embodiments, the heat-generating components of the computing devices may be located/arranged as close as possible to the ultimate intended location for heating, i.e., the internal space.

In some examples, the one or more computing devices comprises a plurality of computing devices, and the plurality of computing devices may be geographically distributed among a plurality of liquid reservoirs, each liquid reservoir being arranged to transfer heat to a respective heating arrangement. Each heating arrangement may then provide heating to a respective internal space.

The internal space may be a room, a cupboard, a heating or cooling device (e.g. an oven or refrigerator), or any other space for which heating (or, if provided the appropriate thermodynamic treatment, cooling) is desired. In some examples, the one or more computing devices and the heating arrangement may be arranged in a building having the internal space, while in other examples, the one or more computing devices may be arranged separately from a building having the internal space, e.g., in another building or structure.

Advantageously, according to the presently disclosed method, the one or more computing devices may be controlled to maximize utilization of the computing capacity. That is, the computing devices may be run as much as possible at any given time, within constraints (some of which are discussed below). In some examples, the one or more computing devices may be kept occupied with computing tasks by maintaining a list of computing tasks for performance, and ensuring that said list always contains at least one computing task.

For example, the computing devices, if no other computing task is provided to them, may be instructed to perform a 'default' computing task such as cryptocurrency mining or a similar task that is 'always available', such that the computing capacity of the one or more computing devices is not underutilized. That is, preferably any computing device may be able to perform a task that is 'always available', and thus an 'always available' task may preferable have no restrictions in respect of which hardware it can be performed on.

It will be appreciated that the maximization of utilization of computing capacity may be maintained even when there is no immediate need for heating from the heating arrangement.

Therefore, according to the presently described method, the hardware of the one or more computing devices may be maximally utilized such that an overall energy usage is optimized. It is realized as a part of the present disclosure that the energy expended to manufacture the hardware components of the computing devices may also be considered in an assessment of the energy usage of the system, and idle computing capacity may thus be an inefficient use of resources, space, and energy. Moreover, a heating arrangement may be more efficiently operated with a readily available source of heat in the liquid reservoir. Furthermore, if the computing devices can be economically operated, waste heat that is generated by such operations, even if not entirely required immediately, may be stored for later use (considering also the thermal insulation of the liquid reservoir).

In some examples, the method may further comprise controlling a temperature of the liquid reservoir towards a set temperature or above a minimum temperature. The set temperature may be an optimal temperature for efficient operation of the heating arrangement, and/or an optimal temperature for efficient operation of the computing components. For example, a central processing unit (CPU) may be selected for a computing device to have improved function at higher temperatures than conventional CPUs. The minimum temperature may be a temperature configured for sterilization (e.g., for killing bacteria) such that the system is advantageously safe for installation into a living space.

Controlling the temperature of the liquid reservoir may further comprise heating the liquid reservoir with an auxiliary heater and/or cooling the liquid reservoir with an auxiliary cooler. Thus, even if the computing devices are not performing computing tasks to generate waste heat, or if not enough waste heat is generated by the computing devices, the liquid reservoir may still be kept at set temperature. Similarly, if the computing devices are operated so as to generate waste heat even when the liquid reservoir is at or above the set temperature, an additional cooler (such as a venting means or active cooler) may 'dump' or counteract (at least some of) the waste heat being provided to the liquid reservoir or internal space.

The configuration of computing devices in this way may allow for an implementation of accompanying software that facilitates a saving of energy and money from both a power-grid and an individual user perspective.

That is, as the one or more computing devices are performing computing tasks, a fee or charge may be paid for said performance. Thus, computing consumers may pay for computing tasks to be performed by the one or more computing devices.

The computing consumers may be the same as or different to the heating consumers - i.e., those who may benefit from the heating provided to the internal space from the waste heat generated by the one or more computing devices.

In a case where the computing consumer(s) is the same as the heating consumer(s), it will be appreciated that an overall energy consumption may be advantageously reduced because the waste heat from the computing devices can be directly and efficiently used for heating instead of or in addition to a dedicated heating for an internal space (e.g., a room).

This may also apply to a case where the computing consumer(s) is not the same as the heating consumer(s), although in this case, the computing consumer(s) may cover at least some of the costs for providing heating to the heating consumers by virtue of paying for the performance of computing tasks.

According to this method of operation, it will be appreciated that a near-constant operation of the one or more computing devices may be desired because, even when heating is not immediately required, fees may still be charged for a performance of computing tasks, said fees being usable to finance the powering of computing devices in the future, for example.

In some examples, the control method may comprise determining an expected heat requirement for the internal space, and idling at least one of the one or more computing devices in response to a determination that an amount of heat stored in the liquid reservoir can satisfy the expected heat requirement, and an expected cost to power the plurality of computing devices is greater than an expected sale price for the performance of the computing tasks.

Sometimes, the sale price (fee, charge) for performance of computing tasks may exceed the cost to power the plurality of computing devices, which can also be viewed as a heating cost. In these cases, it is preferable to 'run' the one or more computing devices (i.e., perform computing tasks) irrespective of heating requirements, because a financial profit may be made for financing potential future heating.

However, during other times, the sale price for performance of computing tasks may not exceed the cost for powering the one or more computing devices, and thus some financial losses may be expected from powering said one or more computing devices. If the current or expected heating requirements are not already satisfied by an amount of heat stored in the liquid reservoir, then the computing devices may nonetheless be run, as the cost of the heating provided thereby is in effect offset by the payment of the sale price for the computing tasks.

In some implementations, a subsidizing actor (such as a governmental agency or a charity) may contribute towards the payment for the performance of computing tasks or otherwise towards the heating from the waste heat and/or any auxiliary heater. Thus, a minimum heating provision may be ensured for no or less cost to the owner/manager of the computing devices - that is, whomever is responsible for paying for the power for the one or more computing devices. In this way, there can also be more than one computing buyer while having one computing consumer. That is, the computing consumer (the beneficiary of the computing task performance) may be a buyer of the computing power and the subsidizing actor may financially contribute towards any difference between the sale price for the computing task performance and the cost to power the computing devices.

On some occasions, the heating requirements may already be satisfied by the heat stored in the liquid reservoir. The heating requirements may be manually input by a user, for example via a user interface of a user device (e.g., a smartphone application), or may be determined by the controller using machine learning (ML)/artificial intelligence (AI) techniques. That is, the controller may 'learn' the habits or trends of the heating requirements of the heating consumer(s), and may further take into account weather or other data into the assessment in respect of current or expected future heating requirements.

The one or more computing devices may be powered by a power grid, which may be managed by a power grid manager. The control decision as to whether run or idle the one or more computing devices may be influenced by a variety of factors, although it will be appreciated that an underlying consideration may be the control of the one or more computing devices to maximize a utilization of their computing capacity to thereby optimize a usage of the hardware and minimize an overall energy usage of the hybrid computing/heating system when providing computing and heating services.

For example, predictions of future power availability or costs may incentivize an automated decision as to whether to perform a computing task at one time or another.

In some examples, the control method may comprise receiving an instruction from a power grid manager to reduce a power consumption of the one or more computing devices, and idling at least one of the one or more computing devices in response to said instruction.

Viewed from the power grid perspective, the one or more computing devices are a controllable load on a power grid. Indeed, in some examples, the computing devices may be geographically distributed across a power grid and may be individually controllable in respect of their location. Thus, a power grid manager may, if desired, issue an instruction to one or more of the computing devices, e.g., in a particular location, to idle, thereby easing a load on a power grid.

The instruction may be scheduled to coincide with a time of (expected) higher load on the power grid such that the power consumption of the one or more computing devices can be tailored to complement the wider patterns of a power grid.

As the computing devices may be expected to be running most of the time, then the plurality of devices may consume a known 'base load' of power. Each device may be configured to indicate if it can be idled and for how long, such that the power grid manager may view the plurality of devices as a predictable base load provider of power when instructed to idle. As such, a plurality of devices on one power grid can constitute a measurable and predictable power grid management function or product that can be provided to the power grid managers.

Additionally or alternatively, the control method may comprise detecting a predetermined condition, and idling at least one of the one or more computing devices in response to detecting said predetermined condition.

The predetermined condition may also be associated with properties of a power grid, such as a detected lowering of a mains frequency or another indicator of especially high load on the power grid, for example as part of some agreement with a power grid manager.

In some examples, the predetermined condition may be associated with a predicted cost differential between the sale price for computing task performance and cost of powering the computing devices at a future time. For example, if it is expected that the performance for a computing task could be sold for a higher sale price and/or the cost for powering the one or more computing devices to perform said computing task could be lower in the (near) future, then the one or more computing devices may be idled until said time in the (near) future, assuming also that there are no immediate heating requirements to be satisfied.

It will be appreciated that a type of generated electricity may also factor into a decision as to whether to perform a computing task at a given time or at a future time. For example, if at a present time, information from the power grid indicates that power is being provided by a non-renewable source, then the performance of a computing task may be delayed until such a time as the power is being provided by a renewable source.

In some examples, the list of computing tasks may comprise a plurality of computing tasks having a criterion for performance, and the list of computing tasks may be ranked based on the respective criteria for said plurality of computing tasks. The computing tasks may then be performed by the one or more computing devices in the order of the ranking.

The criterion may be a cost differential between a sale price for computing tasks and a cost to power the performance of said computing tasks, thereby encouraging computing consumers to offer a greater amount for performance of a computing task to have said computing task performed sooner. The criterion may also be a deadline for performance of the computing task, such that more urgent computing tasks may be performed before less urgent computing tasks.

The list of computing tasks may further comprise information about a utility value for types of hardware in the one or more computing devices, such that the computing tasks may be efficiently allocated with a view to maximizing utilization of the computing capacity of the one or more computing devices.

The one or more computing devices may be owned and managed by a person or company who may prefer that certain types of computing tasks are not performed by their computing device(s). In such cases, computing tasks may be allocated according to their type (e.g., cryptocurrency mining, scientific data processing, etc.) and assigned to a computing device according to their type and the preferences of the owner/manager of the computing device(s).

It will be appreciated that any combination of software and/or hardware may be used to implement the presently disclosed system and control method therefor. For example, the one or more computing devices may be conventional or custom-built computing devices adapted for submersion into a liquid reservoir. The control method may be loaded onto a controller (which may be a single entity or distributed) as a computer program or a computer-readable medium such that a computer or data processing device implementing such a computer program may be caused to carry out the described method. In some examples, portions of the method may be carried out by, or as a result of, a user device's interactions with the controller, in which cases the user device may be considered to form a part of the controller for that time.

In any event, numerous advantages, some of which are described above, may be realized through the use of waste computing heat to provide heat to a heating arrangement in a building. These advantages, as well as others, may be further appreciated through a description of specific illustrated embodiments, all of which fall within the scope of the present disclosure.

### Brief description of the drawings

One or more embodiments will be described, by way of example only, and with reference to the following figures, in which:
Figure 1 schematically shows a building having an internal space that is heated with a heating arrangement using waste computing heat, according to an embodiment of the present disclosure;
Figure 2 illustrates, as a flow diagram, an example method for controlling one or more computing devices, according to an embodiment of the present disclosure; and
Figure 3 illustrates, as a series of steps, a method for controlling one or more computing devices, according to an embodiment of the present disclosure.

### Detailed description

The present disclosure is described in the following by way of a number of illustrative examples. It will be appreciated that these examples are provided for illustration and explanation only and are not intended to be limiting on the scope of the disclosure.

Furthermore, although the examples may be presented in the form of individual embodiments, it will be recognized that the present disclosure also covers combinations of the embodiments described herein.

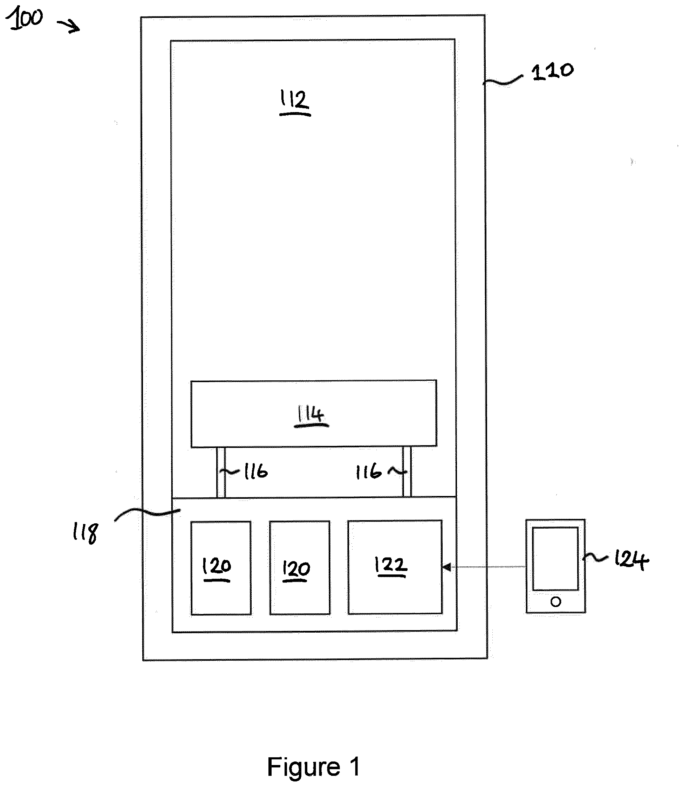

Figure 1 schematically shows a system 100 for performing computing tasks and for heating an internal space 112 in a building 110 using waste heat from performing said computing tasks, according to an embodiment of the present disclosure.

The building 110 may be, for example, an apartment building or an office building, such that the internal space 112 may represent an office or an apartment. A heating arrangement 114 may be arranged in or near the internal space 112 such that it can provide heating services (which may include refrigeration) for the internal space 112.

For example, the heating arrangement 114 may be a conventional central heating system that circulates a heated liquid through pipes and radiators or under-floor heating systems to transport heat to and throughout the internal space 112.

The heating arrangement may be connected via conduits 116 to a liquid reservoir 118 which may provide heated liquid to the heating arrangement 114. In some examples, the conduits 116 may connect directly to the liquid reservoir 118, while in other examples, the conduits 116 may connect to the liquid reservoir 118 indirectly via a heat exchanger.

Two conduits 116 are illustrated in figure 1. One of the conduits 116 may allow heated liquid to pass into the heating arrangement 114 from the liquid reservoir 118, and one of the conduits 116 may allow cooled liquid (having spent its heat in the heating arrangement 114 heating the internal space 112) to pass back from the heating arrangement 114 to the liquid reservoir 118 for further heating. It will be appreciated that more or fewer conduits 116 may be provided, in a similar or alternative arrangement, depending on the implementation.

The heating source in the liquid reservoir may be one or more computing devices 120 performing computing tasks to thereby generate waste heat. The computing devices 120 may be entirely submerged (as illustrated in figure 1) or may only be partially submerged (e.g., in a manner that directs liquid to the primary heat-generating components).

The computing devices 120 may be controlled at least in part by a controller 122. Although the controller 122 is illustrated as a separate component, it will be appreciated that the controller 122 may instead be implemented on one or more of the computing devices 120 or at some remote location.

Among other functions, the controller 122 may control an idle/non-idle state of the one or more computing devices 120, which may be selectively controllable. That is, the controller 122 may control whether the one or more computing devices 120 are 'on' and therefore performing computing tasks, or 'idle' and therefore not performing computing tasks. In some examples, the 'idle' state may be a powered off state, while in other examples, the 'idle' state may be a sleep state despite the computing device 120 still being powered on.

The controller 122 may also host/maintain or provide a list of computing tasks for performance by the one or more computing devices 120. The computing devices 120 may request computing tasks to perform in a 'pull' operation, and/or computing tasks may be provided to the computing devices 120 by the controller 122 in a 'push' operation, depending on the implementation.

For example, the controller 122 may ensure that at least one computing task is available for performance by the computing devices 120 at a given time, such that the computing devices 120 are not unnecessarily idle.

As illustrated in figure 1, the controller 122 may be in communication (i.e., data communication) with a user device 124, such as a smartphone. The controller 122 may be connected to the user device 124 via any suitable wired or wireless connection.

The user device 124 may have a user interface, e.g., implemented by an operating system (OS) such that a user may control and input information into the user device 124 via its user interface. In some examples, such a user may be an inhabitant of the internal space 112, and the user device 124 may be used to provide information in respect of heating requirements or other preferences to the controller 122, for use by the controller 122 in assigning computing tasks to, or deciding whether to idle, the one or more computing devices 120.

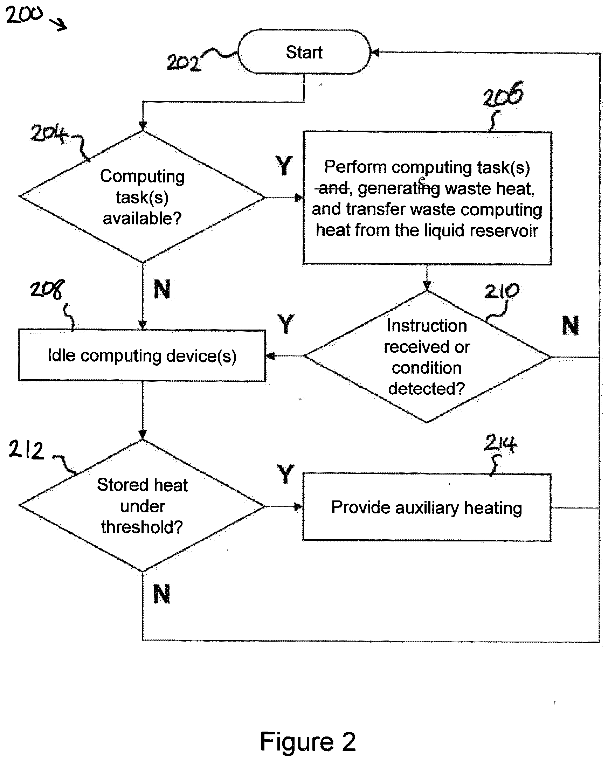

Figure 2 schematically illustrates part of an example control method 200, which may be implemented as a software program running on the controller 122. The reference numerals from figure 1 shall continue during discussion of figure 2 for ease of understanding.

From the start block 202, the control method 200 may comprise determining whether there are computing tasks available (step 204).

The computing tasks may be stored as a list, for performance by the computing devices 120. The list may be maintained so as to contain at least one computing task at any given time, such that hardware of the computing devices 120 is not underutilized. For example, a default computing task may be maintained in the list, such as cryptocurrency mining.

However, it will be appreciated that not all computing tasks can be performed by any hardware, and thus computing tasks may be stored along with information regarding appropriate computing hardware, the category of computing task, and/or similar such information. Computing devices 120 may then assess, or the controller 122 may assess for them, whether there are any computing tasks available that are suitable or possible for them to perform.

If a computing task is available (step 204: Y), a computing device 120 may perform the computing task, i.e., using the CPU, GPU, or any other needed components. Such components may generate waste heat during the performance of the computing task, which may be expended into the liquid reservoir 118 in which the computing devices 120 are submerged. The waste computing heat in the liquid reservoir 118 may then be transferred there from into a heating arrangement 114 as discussed above. These performing, generating, and transferring steps are represented by step 206 of the method 200.

If there are no computing tasks available (step 204: N), the control method 200 may comprise idling (step 208) the computing devices 120. The method 200 may further comprise requesting, seeking, or otherwise sourcing computing tasks for the computing devices 120 to perform. For example, the minimum acceptable sale price for a computing task may be iteratively reduced until a sale of a computing task for performance by the computing devices 120 can be agreed.

One or more of the computing devices 120 may also be idled if an instruction from an appropriate authority - such as a power grid manager or an owner/manager of the computing devices 120 - has been received, or if an appropriate condition has been detected, as discussed above.

In response to receiving such an instruction, or detecting such a condition (step 210: Y), the controller 122 may idle one or more of the computing devices (step 208).

During or in response to an idling of one or more computing devices 120 (step 208), the controller 122 may determined whether the stored heat, i.e., in the liquid reservoir or in a separate storage vessel associated therewith, is under a threshold amount (step 212). The stored heat may be measured as a temperature and or volume, for example.

The threshold amount may be set based on a current temperature of the internal space 112, an expected heating requirement for the internal space 112 (e.g., based on user input, weather conditions, and/or ML/AI-derived predictions), an expected contribution from generated waste heat, and/or other factors, depending on the implementation.

If it is assessed that the stored heat is under the threshold (step 212: Y), the controller 122 may control an auxiliary heater to provide auxiliary heating to the liquid reservoir (step 214) - that is, additional heating that is not from computing waste heat but instead from conventional heating means. For example, the auxiliary heater may be an immersion heater or the like.

It will be appreciated that, in some circumstances, the auxiliary heater may provide auxiliary heating alongside the waste heat provided by the computing devices 120, for example if the heating requirements exceed what can be provided from the waste computing heat alone.

During times when the computing devices 120 are performing computing tasks and no instructions are received or conditions are detected (step 210: N), or after it has been determined that auxiliary heating should be provided, or if the computing devices 120 are idle but the stored heat is not under a threshold amount (step 212: N), the control method 200 may return to the start 202.

For example, the control method 200 may be performed periodically or near-constantly, and may be performed in response to a detection of a change in temperature, a push instruction containing a computing task, after the passage of a length of time, etc., depending on the implementation.

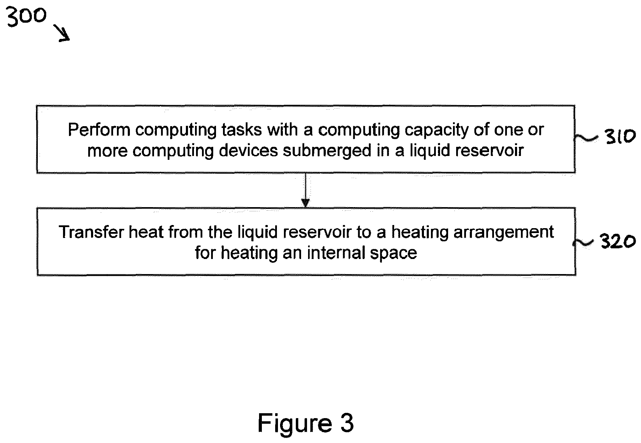

Figure 3 illustrates an example 300 representation of a method for controlling computing devices such as the computing devices 120 shown in figure 1.

As illustrated in figure 3, the method 300 may comprise performing (step 310) computing tasks with a computing capacity of the one or more computing devices, thereby generating waste heat. The one or more computing devices may be at least partially submerged in a liquid reservoir, such that the liquid reservoir is heated by the waste heat, for example as discussed above in relation to figure 1.

The method 300 may further comprise transferring (step 320) heat from the liquid reservoir to a heating arrangement for heating an internal space.

According to this method 300, the one or more computing devices may be controlled to maximize a utilization of the computing capacity, thereby reducing the overall energy consumption and running cost of a system implementing the method 300 (i.e., providing computing and heating). Moreover, by running the computing devices at a maximal capacity for as much of the available time as possible, the energy and resource usage per unit of compute power delivered can be significantly reduced.

Whilst the present disclosure is susceptible to various modifications and alternative forms, specific embodiments are shown and described above by way of example in relation to the drawings, with a view to clearly explaining the various advantageous aspects of the present disclosure. It should be understood, however, that the detailed description herein and the drawings attached hereto are not intended to limit the disclosure to the particular form disclosed. Rather, the intention is to cover all modifications, equivalents, and alternatives falling within the scope of the following claims.

## Claims

1. A method for controlling one or more computing devices, comprising:
performing computing tasks with a computing capacity of the one or more computing devices, thereby generating waste heat;
wherein the one or more computing devices are at least partially submerged in a liquid reservoir, such that the liquid reservoir is heated by the waste heat; and
transferring heat from the liquid reservoir to a heating arrangement for heating an internal space;
wherein the one or more computing devices are controlled to maximize a utilization of the computing capacity.

2. The method according to claim 1, wherein:
the one or more computing devices comprises a plurality of computing devices; and
the plurality of computing devices are geographically distributed among a plurality of liquid reservoirs, each liquid reservoir being arranged to transfer heat to a respective heating arrangement.

3. The method according to claim 1 or claim 2, wherein the one or more computing devices are powered by a power grid, and further comprising:
one or more of:
receiving an instruction from a power grid manager to reduce a power consumption of the one or more computing devices, and
detecting a predetermined condition; and
idling at least one of the one or more computing devices in response to said instruction or detecting said predetermined condition.

4. The method according to any preceding claim, further comprising:
determining an expected heat requirement for the internal space; and
idling at least one of the one or more computing devices in response to a determination that:
an amount of heat stored in the liquid reservoir can satisfy the expected heat requirement; and
an expected cost to power the plurality of computing devices is greater than an expected sale price for the performance of the computing tasks.

5. The method according to any preceding claim, further comprising:
obtaining a list of computing tasks for performance by the computing capacity of the one or more computing devices; and
maintaining the list of computing tasks such that the list of computing tasks contains at least one computing task.

6. The method according to claim 5, wherein:
the list of computing tasks comprises a plurality of computing tasks having a criterion for performance; and
the list of computing tasks is ranked based on the respective criteria for said plurality of computing tasks.

7. The method according to any preceding claim, further comprising:
controlling a temperature of the liquid reservoir towards a set temperature.

8. The method according to claim 7, wherein controlling the temperature of the liquid reservoir further comprises:
heating the liquid reservoir with an auxiliary heater; and/or
cooling the liquid reservoir with an auxiliary cooler.

9. A system comprising:
one or more computing devices at least partially submerged in a liquid reservoir;
a heating arrangement configured to heat an internal space using heat from the liquid reservoir; and
a controller configured to control the one or more computing devices according to the method of any of claims 1 to 8.

10. The system according to claim 9, wherein:
the one or more computing devices are completely submerged in the liquid reservoir.

11. The system according to claim 9 or claim 10, wherein:
the liquid reservoir is in fluid communication with the heating arrangement.

12. The system according to any of claims 9 to 11, further comprising:
a heat exchanger configured to exchange heat between the liquid reservoir and the heating arrangement.

13. The system according to any of claims 9 to 12, further comprising:
a user device having a user interface for receiving user input;
wherein the user device is configured to communicate with the controller based on the user input.

14. The system according to any of claims 9 to 13, wherein:
the liquid reservoir comprises a liquid dielectric.

15. The system according to any of claims 9 to 14, wherein:
the one or more computing devices and the heating arrangement are arranged in a building having the internal space.
